# EUROPEAN PATENT SPECIFICATION

(11) **EP 3 598 491 B1**
(45) Date of publication and mention of the grant of the patent: **02.02.2022**
(21) Application number: 17900977.4
(22) Date of filing: 27.12.2017
(51) Int. Cl.: H01L 25/075, H01L 33/62, F21V 19/00, F21V 23/06

(54) **LIGHT EMITTING DIODE FILAMENT AND LAMP**
LEUCHTDIODENFILAMENT UND LAMPE
FILAMENT DE DIODE ÉLECTROLUMINESCENTE ET LAMPE

(30) Priority: 13.03.2017 CN 201710145266
(43) Date of publication of application: 22.01.2020
(73) Proprietor: Zhejiang Dingxin Arts & Crafts Co., Ltd., Linhai, Zhejiang 317000 (CN)
(72) Inventor: XIANG, Chen, Linhai Zhejiang 317000 (CN)
(74) Representative: de Arpe Fernandez, Manuel
(86) International application number: PCT/CN2017/118824
(87) International publication number: WO 2018/166269

(56) References cited:
- CN-A- 105 098 032
- CN-A- 105 938 866
- CN-A- 106 653 740
- CN-A- 107 101 093
- CN-B- 101 789 422
- CN-U- 204 834 674
- CN-U- 205 584 538
- US-A1- 2009 154 156
- US-A1- 2014 312 365

## Description

### FIELD OF THE DISCLOSURE

The disclosure relates to a filament field, and more particularly to a LED filament and a lamp.

### BACKGROUND

A revolutionarily novel light source LED derived from the 20^{th} century has rapidly been popular on the illumination market due to advantages such as energy conservation and environment protection, as well as the long service life. The LED has become the mainstream light source in the future to be widely applied in commercial illumination, industrial illumination, outdoor illumination, etc. But the development of the LED is relatively slow in civil illumination. A LED lamp was too new to be heard about for most people. A LED filament bulb introduced by Ushio Lighting changed the situation in 2008. The bulb lamp is an incandescent lamp disposed with the LED, which keeps the conventional look but upgrades the recipe. The LED lamp can be seen to be used for illumination by its appearance. Candle lamps, quartz lamps and bulbs utilizing LED filaments as light sources initiate to be launched in large amounts subsequently, and accepted by more and more consumers.

A Chinese patent publication No. CN104241501A disclosed an all-direction plant growth lamp LED filament, including a long-strip-shaped transparent substrate and metal supports fixed to the two ends of the transparent substrate. A plurality of blue light LED chips are fixed to the transparent substrate and form one or more lines of LED strings penetrating through the transparent substrate, and the blue light LED chips in each LED string are connected in series through a wire; the blue light LED chips located at the two ends of the transparent substrate are connected to the supports through wires respectively; the exterior of the transparent substrate is wrapped by a red fluorescent powder layer, and the red fluorescent powder layer is formed by mixing red fluorescent powder and a cross-linking agent. Moreover, an U.S. patent publication No. US2009/0154156A1, entitled "Integrally Formed Single Piece Light Emitting Diode Light Wire and Uses Thereof", disclosed an integrally formed single piece LED light wire includes a conductive base and a plurality of LEDs, the conducive base has two conductive bus elements spaced from each other, and each of the plurality of LEDs is disposed onto one of the two conductive bus element and wire bonded onto the other of the two conductive bus element. Another U.S. patent publication No. US2014/0312365A1, entitled "Alternating Current Light-Emitting Device", disclosed a lighting device includes two frames spaced from each other and a plurality of alternating current light-emitting devices attached to the two frames by support leads/wires. In addition, another Chinese patent No. CN101789422B, entitled "Light-Emitting Diode Module", disclosed a light-emitting diode module includes a metal bracket having a power bracket bar and a grounding bracket bar and a plurality of LED groups connected between the power bracket bar and the grounding bracket bar by wires.

The slight deformation of a conventional LED filament will lead to the line rupture or destruction of the LED chip, which will cause the LED filament to break down.

### SUMMARY

In order to solve the problem above, the disclosure provides a LED filament that is not easily destroyed.

In order to achieve the advantage above, the disclosure provides a LED filament, including a plurality of LED chips, a first bracket and a second bracket. The LED chips are securely connected with the first bracket and/or the second bracket. The first bracket and the second bracket are made out of metal. Two ends of the LED chips are each electrically connected with the first bracket and the second bracket, or the plurality of LED chips are divided into groups of serially connected LED chips. Two ends of each of the groups of serially connected LED chips are electrically connected with the first bracket and the second bracket. The first bracket includes a die bonding section. The die bonding section includes a die bonding region and a connection region. The die bonding region and the connection region are spaced apart. A cross-sectional area of the die bonding region is larger than a cross-sectional area of the connection region. The LED chips are fixed in the die bonding region. A cross-sectional area of the die bonding section gradually decreases from middle of the die bonding region to middle of the connection region.

In an embodiment of the disclosure, the second bracket includes a power supply section, the power supply section includes a third region and a fourth region, the third region and the fourth region are spaced apart, a cross-sectional area of the third region is smaller than a cross-sectional area of the fourth region, the die bonding region and the third region are corresponding, and a cross-sectional area of the power supply section gradually increases from middle of the third region to middle of the fourth region.

In an embodiment of the disclosure, the die bonding region and the connection region are plate-shaped structures. A first border of the die bonding region and the connection region adjacent to the second bracket and a surface of the die bonding region fixing the LED chips are perpendicular. A sectional curve of the first border and the surface of the die bonding region fixing the LED chips is a sinusoid.

In an embodiment of the disclosure, a gap is between the first bracket and the second bracket.

In an embodiment of the disclosure, the first bracket and the second bracket are wrapped by a transparent layer.

In an embodiment of the disclosure, a first lead and a second lead are extended out of the transparent layer from the first bracket and the second bracket.

In an embodiment of the disclosure, the second lead is located on an end of the second bracket adjacent to the first lead.

In an embodiment of the disclosure, the first bracket and the second bracket are mutually fixed by an insulating member.

In an embodiment of the disclosure, the insulating member is made out of epoxy resin.

In the disclosure, as the LED chips or each of the groups of LED chips are parallel connected, even though parts of the LED chips are destroyed or the wire is broken, the LED filament will not be completely destroyed.

### BRIEF DESCRIPTION OF THE DRAWINGS

FIG. 1 is a structural schematic view of a LED filament according to a first embodiment of the disclosure.
FIG. 2 is a structural schematic view of a first bracket and a second bracket of the LED filament of FIG. 1.
FIG. 3 is a locally enlarged view of a middle section of the first bracket and the second bracket of FIG. 2.
FIG. 4 is a cross-sectional view of FIG. 3 taken along 1-1 and 2-2.
FIG. 5 is a structural schematic view of a LED filament according to a second embodiment of the disclosure.
FIG. 6 is a structural schematic view of a LED filament according to a third embodiment of the disclosure.
FIG. 7 is a structural schematic view of a LED filament according to a fourth embodiment of the disclosure.
FIG. 8 is a structural schematic view of a LED filament according to a fifth embodiment of the disclosure.
FIG. 9 is a structural schematic view of a LED filament according to a sixth embodiment of the disclosure.
FIG. 10 is a structural schematic view of a LED filament according to a sixth embodiment of the disclosure.
FIG. 11 is a structural schematic view of a LED filament according to a seventh embodiment of the disclosure.
FIG. 12 is a cross-sectional view of FIG. 11 taken along 3-3.

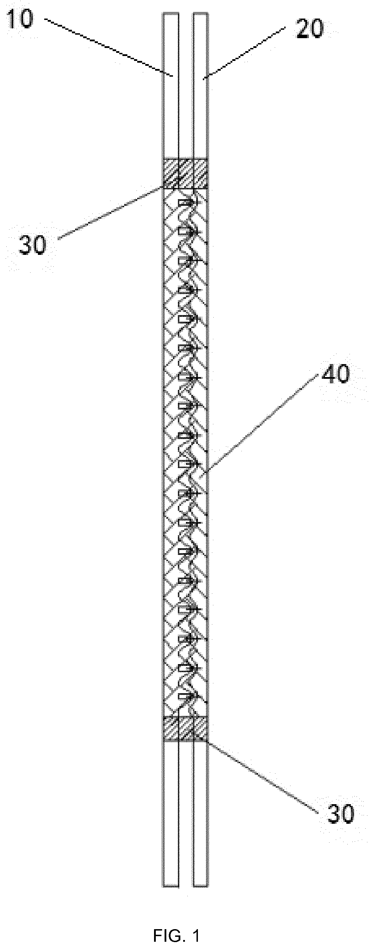

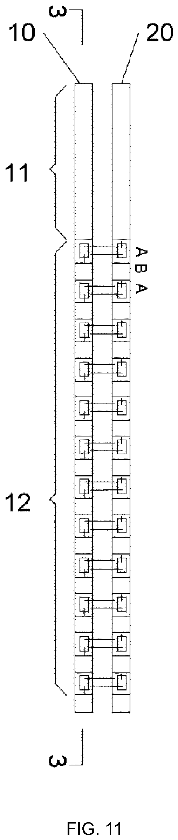

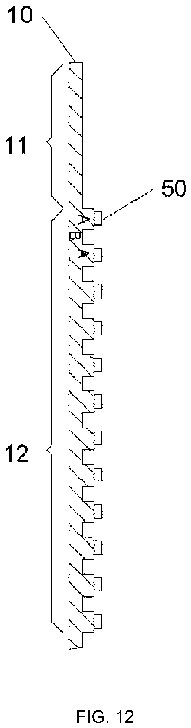

The first six embodiments, depicted in Figures 1-10, are embodiments falling within the scope of the claimed invention. The seventh embodiment, depicted in figure 11 and 12, is an illustrative embodiment falling outside the scope of the claimed invention.

### DETAILED DESCRIPTION OF PREFERRED EMBODIMENTS

In order to further illustrate embodiments employed by the disclosure to achieve the predesignated objective and the efficacy, concrete embodiments, structures, features and the efficacy thereof provided according to the disclosure will be described in detail with reference to preferred embodiments and the accompanying drawings as follows.

Referring to FIG. 1, the LED filament of the embodiment includes a first bracket 10, a second bracket 20, insulating members 30 configured to fix the first bracket 10 and the second bracket 20, and a transparent layer 40 wrapping the middle of the first bracket 10 and the second bracket 20. The insulating members 30 are located adjacently to ends of the first bracket 10 and the second bracket 20. The insulating members 30 are preferably to be made out of the epoxy resin. The insulating members 30 can obviously be made out of plastic or rubber as well.

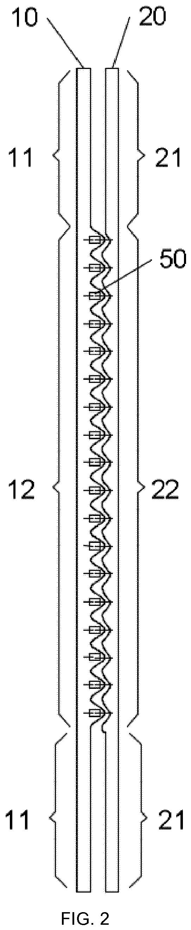

Referring to FIG. 2, the first bracket 10 is divided into first leads 11 and a die bonding section 12. The first leads 11 are located on two ends of the die bonding section 12. The second bracket 20 includes second leads 21 and a power supply section 22. The second leads 21 are located on two ends of the power supply section 22. The first leads 11 and the second leads 21 are configured to connect with a power supply circuit. A gap is between the first bracket 10 and the second bracket 20, which means the first bracket 10 and the second bracket 20 are separated/insulated from each other. The gap between the first bracket 10 and the second bracket 20 is filled with the transparent layer 40. The LED filament further includes a plurality of LED chips 50. The plurality of LED chips 50 are fixed on the upper surface of the die bonding section 12 to be a line evenly. In other embodiments, the bottom surface of the die bonding section is also fixed with the plurality of LED chips 50. The transparent layer can be a silica layer, an epoxy resin layer, a florescent adhesive layer prepared by silica and florescent powders.

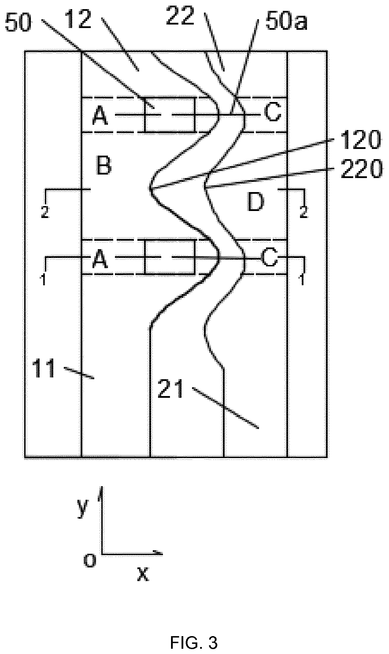

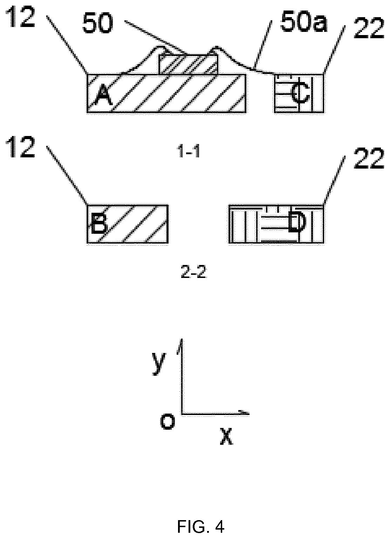

Referring to FIGS 3 and 4, the die bonding section 12 is a die bonding region A and a connection region B, which are spaced apart. A cross-sectional area of the die bonding region A is larger than a cross-sectional area of the connection region B. The cross-sectional area is the area of a cross section perpendicular to a lengthwise direction of the first bracket. A width of the die bonding region A is larger than a width of the connection region. The width is the length of the direction x in FIG. 3. The LED chips 50 are fixed on the upper surface of the die bonding region A. According to the invention, a cross-sectional area gradually decreases from the middle of the die bonding region A to the middle of the connection region B. A first border 120 of the die bonding section 12 towards the power supply section 22 is an undulation surface. The first border 120 is perpendicular to and the surface of the die bonding section 12 fixing the LED chips 50. A sectional curve of the first border 120 and the surface of the die bonding section 12 fixing the LED chips 50 is a sinusoid x=A₁sin(ω π y+ Φ )+k₁. The die bonding region and the connection region are plate-shaped structures.

x is a variable of a direction from one end to the other end of the first border 120 perpendicular to the power supply section.

A₁ is the amplitude. A₁ can be 0.5mm.

Φ is the original phase, aka the phase when x=0, which is the curve shifts up and down reflected on the coordinate.

k₁ and k₂ are the setover, which are the curve shifts left and right reflected on the coordinate.

ω is an angular velocity, which controls the frequency of vibration of the curve.

The power supply section 22 is a third region C and a fourth region, which are spaced apart. A cross-sectional area of the third region C is smaller than a cross-sectional area of the fourth region D. A width of the third region C is smaller than a width of the fourth region D. Preferably, a cross-sectional area gradually increases from the middle of the third region C to the middle of the fourth region D. The die bonding region A and the third region C are corresponding. The width of the connection region B and the fourth region D can be relatively small correspondingly to the LED filament. The LED chips 50 are electrically connected with the die bonding region A of the die bonding section 12 and the third region C of the power supply section 22 by a wire 50a in the embodiment. The LED chips 50 are electrically connected with the die bonding region A of the die bonding section 12 and the fourth region D of the power supply section 22 by the wire 50a in another embodiment.

A second border 220 of the power supply section 22 towards the die bonding section 12 is likewise an undulation surface. The second border 220 and the surface of the die bonding section 12 fixing the LED chips 50 are perpendicular. A sectional curve of the second border 220 and the surface of the die bonding section 12 fixing the LED chips 50 is a sinusoid x=A₂sin( ω π y+ Φ )+k₂, where y is a variable of the first border 120 in a direction from one end to the other end of the power supply section.

x is a variable of a direction from one end to the other end of the first border 120 perpendicular to the power supply section.

A₂ is the amplitude. A₁ is larger than A₂. A₂ can be 0.25mm.

Φ is the original phase, aka the phase when x=0, which is the curve shifts up and down reflected on the coordinate.

k₁ and k₂ are the setover, which are the curve shifts left and right reflected on the coordinate.

ω is an angular velocity, which controls the frequency of vibration of the curve.

Two ends of the LED chips 50 are connected with the die bonding section 12 and the power supply section 22 by the wire 50a.

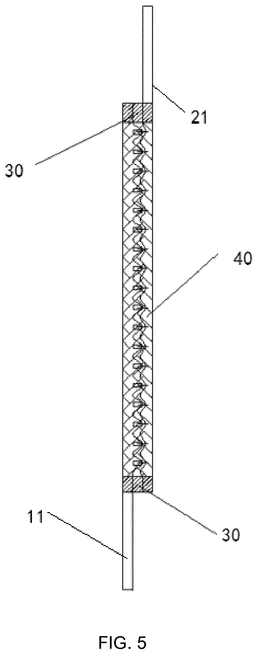

Referring to FIG. 5, in the embodiment, the first lead 11 is located on one end of the die bonding section. The second lead 21 is located on the end of the power supply section far from the first lead 11.

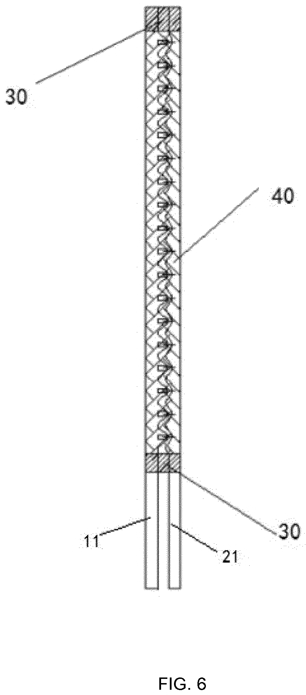

Referring to FIG. 6, in the embodiment, the first lead 11 is located on one end of the die bonding section. The second lead 21 is located on the end of the power supply section adjacent to the first lead 11.

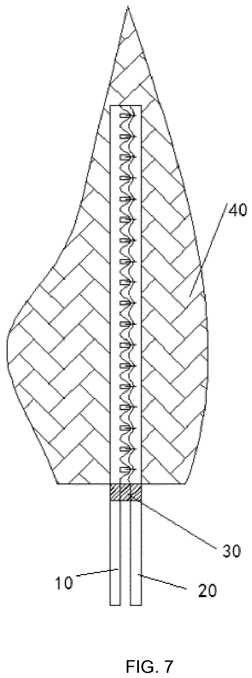

Referring to FIG. 7, in the embodiment, the transparent layer 40 is a flame-shaped structure.

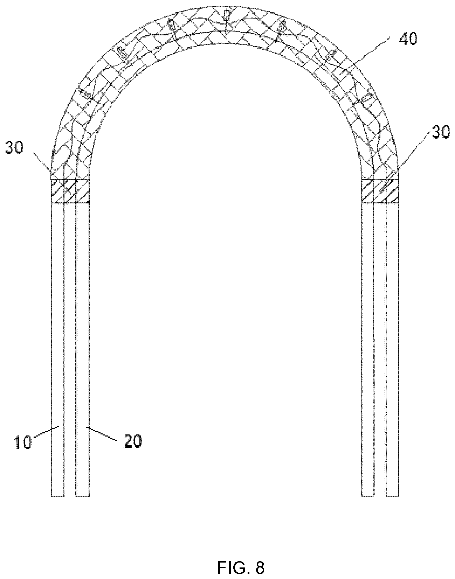

Referring to FIG. 8, in the embodiment, the die bonding section and the power supply section in the middle of the first bracket 10 and the second bracket 20 are arcs.

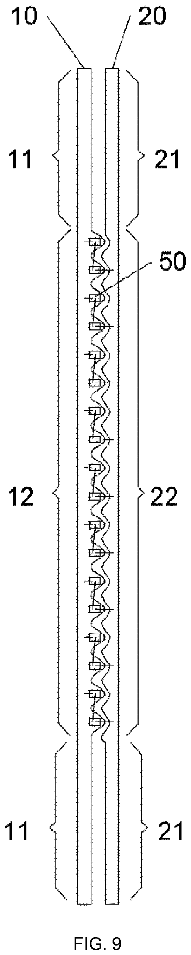

Referring to FIG. 9, in the embodiment, every two LED chips are serially connected to be a group of LED chips. Two ends of each of the groups of LED chips are electrically connected to the first bracket 10 and the second bracket 20 respectively. So that the power supply can be 6V.

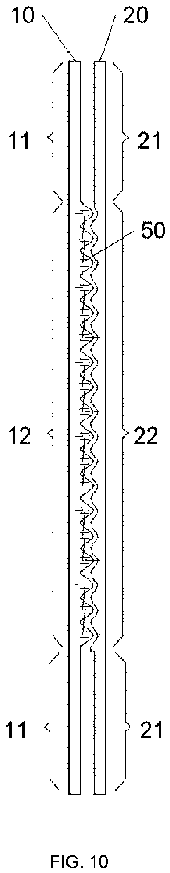

Referring to FIG. 10, in the embodiment, every three LED chips are serially connected to be a group of LED chips. Two ends of each of the groups of LED chips are electrically connected to the first bracket 10 and the second bracket 20 respectively. So that the power supply can be 9V.

Referring to FIG. 11 and FIG. 12, in the illustrative embodiment falling outside the scope of the invention, the structure of the first bracket 10 and that of the second bracket 20 are the same. The die bonding region A of the first bracket 10 is a convex shape. The first bracket 10 and the second bracket 20 are both fixed with multiple LED chips. Two ends of the LED chips are electrically connected with the first bracket 10 and the second bracket 20.

Overall, the LED filament of the disclosure at least has following advantages.

The cross-sectional area of the die bonding region is larger than that of the connection region in the disclosure, so that the deformation of connection region is considerable and the deformation of the die bonding region is subtle when the LED filament suffers forces, and the LED chips will not be destroyed easily.

In the disclosure, as the LED chips or each of the groups of LED chips are parallel connected, even though parts of the LED chips are destroyed or the wire is broken, the LED filament will not be completely destroyed.

The descriptions above are merely preferred embodiments of the disclosure, which cannot limit the protection scope of the invention. Although the invention is disclosed with reference to the preferred embodiments previously, the invention will not be restricted as such. A person skilled in the art can achieve equivalent embodiments such as modification according to the disclosed embodiments. Any such simple modification or equivalent transformation falling within the scope of the appended claims form part of the invention.

## Claims

1. A LED filament, comprising a plurality of LED chips (50), a first bracket (10) and a second bracket (20), the plurality of LED chips (50) being secured on the first bracket (10) and/or the second bracket (20), the first bracket (10) and the second bracket (20) made out of metal;
two ends of each of the plurality of LED chips (50) being electrically connected with the first bracket (10) and the second bracket (20) respectively; or the plurality of LED chips (50) being divided into groups of serially connected LED chips, and two ends of each of the groups of serially connected LED chips being electrically connected with the first bracket (10) and the second bracket (20) respectively;
the first bracket (10) comprises a die bonding section (12), the die bonding section (12) comprises a die bonding region (A) and a connection region (B), the die bonding region (A) and the connection region (B) are spaced apart, a cross-sectional area of the die bonding region (A) is larger than a cross-sectional area of the connection region (B), the die bonding region (A) has the LED chip (50) fixed therein;
**characterized in that**: a cross-sectional area of the die bonding section (12) gradually decreases from middle of the die bonding region (A) to middle of the connection region (B).

2. The LED filament according to claim 1, wherein the second bracket (20) comprises a power supply section (22), the power supply section (22) comprises a third region (C) and a fourth region (D), the third region (C) and the fourth region (D) are spaced apart, a cross-sectional area of the third region (C) is smaller than a cross-sectional area of the fourth region (D), the die bonding region (A) and the third region (C) are corresponding, and a cross-sectional area of the power supply section (22) gradually increases from middle of the third region (C) to middle of the fourth region (D).

3. The LED filament according to claim 1, wherein the die bonding region (A) and the connection region (B) are plate-shaped structures, a first border (120) of the die bonding region (A) and the connection region (B) adjacent to the second bracket (20) is perpendicular to a surface of the die bonding region (A) fixing the LED chips (50), a sectional curve of the first border (120) and the surface of the die bonding region (A) fixing the LED chips (50) is a sinusoid.

4. The LED filament according to claim 3, wherein a gap is between the first bracket (10) and the second bracket (20).

5. The LED filament according to claim 1, wherein the first bracket (10) and the second bracket (20) are wrapped by a transparent layer (40).

6. The LED filament according to claim 5, wherein a first lead (11) and a second lead (21) are extended out of the transparent layer (40) from the first bracket (10) and the second bracket (20).

7. The LED filament according to claim 6, wherein the second lead (21) is located on an end of the second bracket (20) adjacent to the first lead (11).

8. The LED filament according to any one of claims 1 to 7, wherein the first bracket (10) and the second bracket (20) are mutually fixed together by an insulating member (30).

9. The LED filament according to claim 8, wherein the insulating member (30) is made of an epoxy resin.

10. A lamp, wherein the lamp comprises the LED filament according to any one of claims 1 to 9 as a light source.

## Patentansprüche

1. LED-Glühfaden, umfassend mehrere LED-Chips (50), eine erste Halterung (10) und eine zweite Halterung (20), wobei die mehreren LED-Chips (50) an der erste Halterung (10) befestigt sind und/oder die zweite Halterung (20), die erste Halterung (10) und die zweite Halterung (20) aus Metall bestehen;
zwei Enden von jedem der Vielzahl von LED-Chips (50) elektrisch mit der erste Halterung (10) bzw. der zweite Halterung (20) verbunden sind; oder die Vielzahl von LED-Chips (50) in Gruppen von seriell verbundenen LED-Chips unterteilt ist und zwei Enden jeder der Gruppen von seriell verbundenen LED-Chips elektrisch mit der erste Halterung (10) bzw. der zweite Halterung (20) verbunden sind;
die erste Halterung (10) einen Die-Bond-Abschnitt (12) umfasst, der Die-Bond-Abschnitt (12) einen Die-Bond-Bereich (A) und einen Verbindungsbereich (B) umfasst, den Die-Bond-Bereich (A) und den Verbindungsbereich (B) voneinander beabstandet sind, eine Querschnittsfläche des Die-Bonding-Bereichs (A) größer ist als eine Querschnittsfläche des Verbindungsbereichs (B), der Die-Bonding-Bereich (A) hat den LED-Chip (50) fixiert darin;
**dadurch gekennzeichnet, dass**: eine Querschnittsfläche des Die-Bond-Abschnitt (12) von der mitte des Die-Bond-Bereich (A) zur mitte des Verbindungsbereichs (B) allmählich abnimmt.

2. LED-Glühfaden nach Anspruch 1, wobei die zweite Halterung (20) einen Stromversorgungsabschnitt (22) umfasst, der Stromversorgungsabschnitt (22) einen dritten Bereich (C) und einen vierten Bereich (D) umfasst, der dritte Bereich ( C) und der vierte Bereich (D) beabstandet sind, eine Querschnittsfläche des dritten Bereichs (C) kleiner ist als eine Querschnittsfläche des vierten bereichs (D), des Die-Bond-Bereichs (A) und der dritten Region (C) entsprechen, und eine Querschnittsfläche des Stromversorgungsabschnitts (22) von der mitte des dritten Bereichs (C) zur mitte des vierten Bereichs (D) allmählich zunimmt.

3. LED-Glühfaden nach Anspruch 1, wobei der Die-Bond-Bereich (A) und der Verbindungsbereich (B) plattenförmige Strukturen sind, eine erste Grenze (120) des Die-Bond-Bereich (A) und des Verbindungsbereichs (B) angrenzend an die zweite Halterung (20) ist senkrecht zu einer Oberfläche des Die-Bonding-Bereichs (A), der die LED-Chips (50) befestigt, einer schnittkurve des erste Grenze (120) und der Oberfläche des Die-Bonding-Bereichs (A) fixieren der LED-Chips (50) ist eine Sinuskurve.

4. LED-Glühfaden nach Anspruch 3, wobei zwischen der erste Halterung (10) und der zweite Halterung (20) eine Lücke ist.

5. LED-Glühfaden nach Anspruch 1, wobei die erste Halterung (10) und die zweite Halterung (20) von einer transparenten Schicht (40) umhüllt sind.

6. LED-Glühfaden nach Anspruch 5, wobei eine erste Leitung (11) und eine zweite Leitung (21) aus der transparenten Schicht (40) von der erste Halterung (10) und der zweite Halterung (20) herausragen.

7. LED-Glühfaden nach Anspruch 6, wobei sich die zweite Leitung (21) an einem Ende der zweite Halterung (20) neben der erste Leitung (11) befindet.

8. LED-Glühfaden nach einem der Anspruch 1 bis 7, wobei die erste Halterung (10) und die zweite Halterung (20) gegenseitig durch ein Isolierelement (30) aneinander befestigt sind.

9. LED-Glühfaden nach Anspruch 8, wobei das Isolierelement (30) aus einem Epoxidharz besteht.

10. Lampe, wobei die Lampe den LED-Glühfaden nach einem der Anspruch 1 bis 9 als Lichtquelle umfasst.

## Revendications

1. Filament LED, comprenant une pluralité de puces LED (50), un premier support (10) et un deuxième support (20), la pluralité de puces LED (50) étant fixée sur le premier support (10) et/ou le deuxième support (20), le premier support (10) et le deuxième support (20) en métal;
deux extrémités de chacune de la pluralité de puces LED (50) étant connectées électriquement au premier support (10) et au deuxième support (20) respectivement; ou la pluralité de puces LED (50) étant divisée en groupes de puces LED connectées en série, et deux extrémités de chacun des groupes de puces LED connectées en série étant connectées électriquement au premier support (10) et au deuxième support (20) respectivement;
le premier support (10) comprend une section de connexion de puce (12), la section de connexion de puce (12) comprend une région de collage de puce (A) et une région de connexion (B), la région de collage de puce (A) et la région de connexion (B) sont espacés, une zone de section transversale de la région de collage de puce (A) est plus grande qu'une zone de section transversale de la région de connexion (B), la puce LED (50) est fixée à la région de collage de puce (A);
**caractérisé en ce que**: une aire de section transversale de la section de liaison de puce (12) diminue progressivement du milieu de la région de collage de puce (A) au milieu de la région de connexion (B).

2. Filament LED selon la revendication 1, dans lequel le deuxième support (20) comprend une section d'alimentation (22), la section d'alimentation (22) comprend une troisième région (C) et une quatrième région (D), la troisième région (C) et la quatrième région (D) sont espacées, une aire en coupe transversale de la troisième région (C) est plus petite qu'une aire en coupe transversale de la quatrième région (D), la région de collage de puce (A) et la troisième région (C) sont correspondantes, et une section transversale de la section d'alimentation(22) augmente progressivement du milieu de la troisième région (C) au milieu de la quatrième région (D).

3. Filament LED selon la revendication 1, dans lequel la région de collage de puce (A) et la région de connexion (B) sont des structures en forme de plaque, une première bordure (120) de la région de collage de puce (A) et la région de connexion (B) adjacent au deuxième support (20) est perpendiculaire à une surface de la région de collage de puce (A) fixant les puces LED (50), une courbe en coupe de la première bordure (120) et la surface de la région de collage de puce (A) la fixation des puces LED (50) est une sinusoïde.

4. Filament LED selon la revendication 3, dans lequel un espace se trouve entre le premier support (10) et le deuxième support (20).

5. Filament LED selon la revendication 1, dans lequel le premier support (10) et le deuxième support (20) sont enveloppés par une couche transparente (40).

6. Filament LED selon la revendication 5, dans lequel un premier fil (11) et un deuxième fil (21) s'étendent hors de la couche transparente (40) à partir du premier support (10) et du deuxième support (20).

7. Filament LED selon la revendication 6, dans lequel le deuxième fil (21) est situé sur une extrémité du deuxième support (20) adjacente au premier fil (11).

8. Filament LED selon l'une quelconque des revendications 1 à 7, dans lequel le premier support (10) et le deuxième support (20) sont mutuellement fixés ensemble par un élément isolant (30).

9. Filament LED selon la revendication 8, dans lequel l'élément isolant (30) est en résine époxy.

10. Lampe, dans laquelle la lampe comprend le filament LED selon l'une quelconque des revendications 1 à 9 en tant que source lumineuse.
